# EUROPEAN PATENT SPECIFICATION

(11) **EP 1 189 156 B1**
(45) Date of publication and mention of the grant of the patent: **15.10.2003**
(21) Application number: 00830557.5
(22) Date of filing: 03.08.2000
(51) Int. Cl.: G06F 17/50

(54) **Computer-assisted design system**
Rechnergestütztes Entwurfssystem
Système de conception assisté par ordinateur

(43) Date of publication of application: 20.03.2002
(73) Proprietor: FIATAVIO S.p.A., 10127 Torino (IT)
(72) Inventor: Caroni, Leonardo, 10100 Torino (IT); Barbero, Giorgio, 10129 Torino (IT); Moretto, Ivano, 10084 Rivarolo Canavese (IT)
(74) Representative: Franzolin, Luigi

(56) References cited:
- EP-A- 0 451 371
- US-A- 5 339 247

## Description

The present invention relates to a computer-assisted design system.

As is known, in manufacturing, new products and/or components are normally designed with reference to and by improving and refining earlier design work, which may comprise completed and/or rough projects and associated technical/scientific know-how.

In large companies, however, all or part of the earlier design work carried out by the company is not always available to design personnel as a whole, so that certain projects, or parts of them, already developed by the company are developed again from scratch, thus resulting in obvious waste in terms of time and human resources.

US 5,339,247 is cited as prior art.

Another well-known fact is the extent to which' design work is complicated by difficulties in obtaining access to earlier design work and/or the technical/scientific know-how involved in developing new projects.

Also known is the extent to which, in most cases, companies are ill-advised to depart from proven design practices.

It is an object of the present invention to provide a computer-assisted design system enabling complete, troublefree access to company design records, so as to assist and guide design personnel in solving technical problems arising in the course of new projects.

Further technical problems the present invention is designed to solve include:
. consolidating in-house technical/scientific know-how;
. expediting design procedures;
. improving the performance of newly designed components and/or products;
. cutting design time and cost.

According to the present invention, there is provided a computer-assisted design system as claimed in Claim 1.

A preferred, non-limiting embodiment of the invention will be described by way of example with reference to the accompanying drawings, in which:
Figures 1a, 1b show a block diagram of a computer-assisted design system in accordance with the teachings of the present invention;
Figures 2a-2e show video displays relative to the system according to the present invention.

The computer-assisted design system according to the present invention may be used to advantage by companies, in particular medium-large companies, engaged in the design and possibly also the manufacture of products and/or components.

The system can be implemented on a known central processing unit connected over a data network (e.g. local data network) to a number of terminal stations (e.g. personal computers), each with a central unit, keyboard, video terminal and mouse.

Each station is manned by at least one operator.

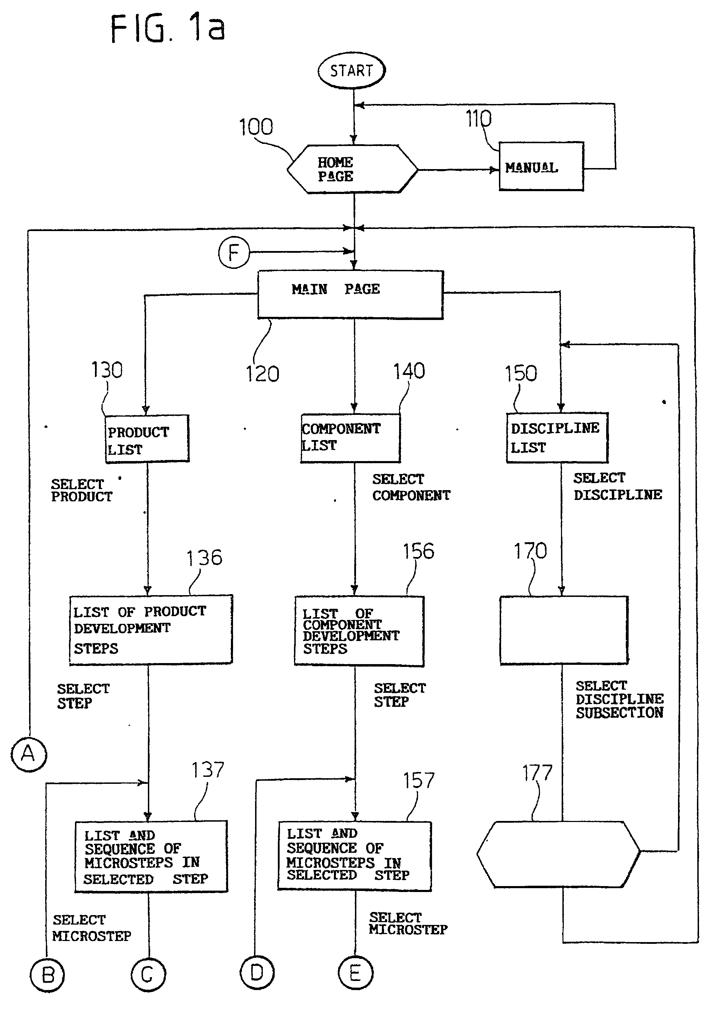

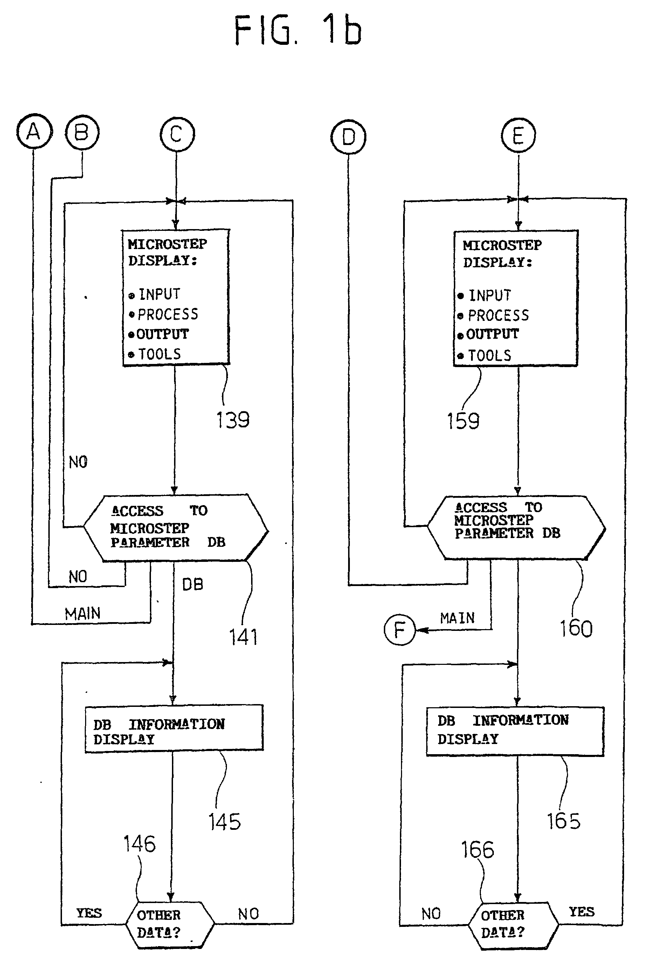

Figure 1 shows a simplified block diagram of the operations performed by the system according to the present invention.

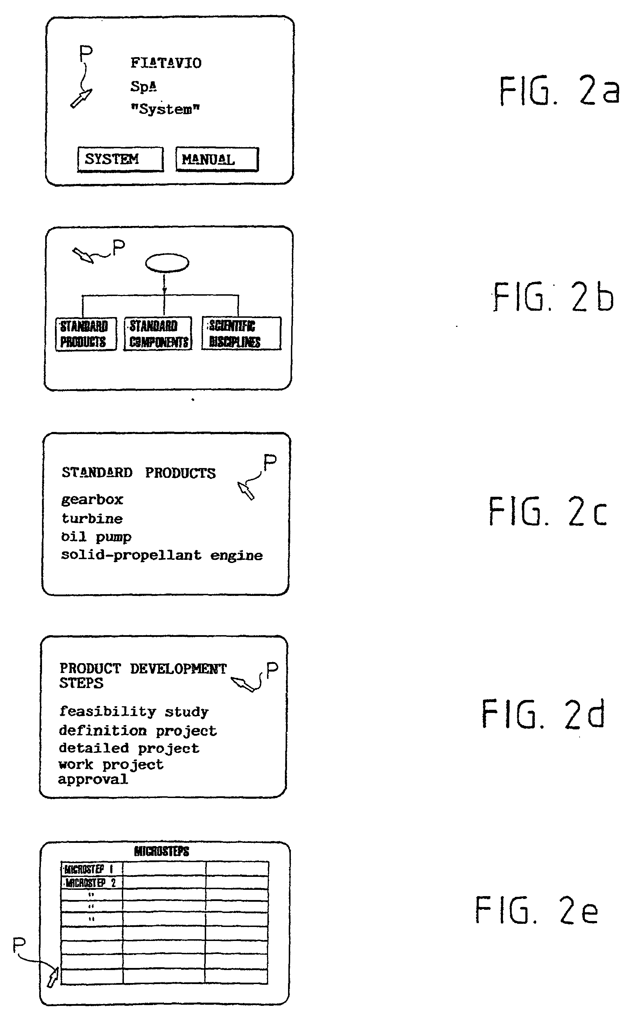

To begin with, a first block 100 displays a first video page (HOME PAGE, Figure 2a) showing general information about the computer-assisted design system, such as the system name and reference, system title, and any confidentiality clauses governing use of the system and the system-stored data.

Block 100 allows the operator at least two system operation choices:
. initiate an inquiry procedure by which to consult information relative to the overall structure and operation of the system (block 110 after block 100) and which, as a whole, defines a system operating manual;
. initiate a system inquiry procedure (block 120 after block 100).

Blocks 110 and 120 are selected using normal graphic environment (e.g. WINDOWS environment) means, i.e. using a mouse to manually position the cursor P at distinct points on the screen corresponding to initiation of the manual inquiry (MANUAL) and system enquiry (SYSTEM) procedures, and then manually operating, e.g. double clicking, the mouse to select block 110 or 120.

At the end of the manual inquiry procedure, block 110 goes back to block 100.

Block 120 displays a second video page (MAIN PAGE, Figure 2b) from which the operator can choose between at least three operating modes:
. a first operating mode (block 130 after block 120) wherein the system supplies operating data relative to standard in-house products, i.e. products designed and/or manufactured by the company operating the system;
. a second operating mode (block 140 after block 120) wherein the system supplies operating data relative to standard in-house components, i.e. physical components designed and/or manufactured by the company operating the system;
. a third operating mode (block 150 after block 120) wherein the system supplies operating data relative to scientific disciplines used in the design of standard in-house products and/or components.

In this case, too, blocks 130, 140, 150 are selected using normal graphic environment (e.g. WINDOWS environment) means, i.e. using a mouse to manually position the cursor P at distinct points on the screen corresponding to the first, second and third operating modes, and then manually operating, e.g. double clicking, the mouse to select block 130, 140 or 150.

More specifically, the term "component" is intended to mean a distinct physical entity, which may comprise several parts (e.g. a casting, gear, bearing, shaft); while "product" is intended to mean an assembled group of components (e.g. a gearbox comprising a casting and several gears, bearings and shafts).

Block 130 displays a third video page (PRODUCT PAGE, Figure 2c) showing a list of n standard in-house products, such as:
. product 1 (gearbox);
. product 2 (turbine);
. ...
. i-th product (oil pump);
. ...
. n-th product (solid-propellant engine).

Each product in the block 130 list is also selected using normal known graphic environment means.

When a given product in the list is selected (e.g. gearbox), block 130 goes on to a block 136, which displays a fourth video page (PRODUCT DEVELOPMENT STEPS PAGE, Figure 2d) showing a list of m steps necessary to develop the standard product selected:
. step 1 (feasibility study);
. step 2 (definition project);
. step 3 (detailed project);
. i-th step (work project):
. m-1-th step (testing);
. m-th step (approval).

In the case of the example shown (gearbox), block 136 indicates the various steps necessary to develop the gearbox :
. gearbox feasibility study;
. gearbox definition project;
. detailed gearbox project;
. gearbox work project;
. gearbox testing;
. gearbox approval.

One or more of the block 136 steps can be selected by the operator, again using known graphic environment selection means.

When a given step in the list is selected, block 136 is followed by a block 137, which displays a fifth video page (MICROSTEP PAGE, Figure 2e) showing a number of microsteps, which together define the selected step. The order in which the microsteps are listed corresponds to the logical and/or time sequence of the jobs involved in performing the selected step; and each microstep indicates the procedures to be performed in the microstep itself, as characterized by mathematical formulas and input and output parameters.

The microstep sequence and content are based on previous in-house design experience.

When a given microstep in the block 137 list is selected, block 137 goes on to a block 139, which provides for expanding the selected microstep, i.e. indicates, in as much detail as the system allows, the operations involved in the microstep according to previous in-house design experience. It should be pointed out that the term "design" may be intended in the sense of the ISO 10303 STEP specification, i.e. that company process which commences with identification of customer requirements, and terminates when all the information, tools and materials are available for product manufacture and marketing.

Expansion of the selected microstep may, for example, comprise displaying tables based on past in-house design experience.

Block 139 may display for each microstep:
. microstep input parameter tables;
. microstep output parameter tables;
. microstep processing procedures;
. useful microstep tools, e.g. program and processing code lists.

Block 139 is followed by a block 141 enabling operator access to:
. block 120 (MAIN block) showing the main video page from which to make a further product, component or discipline option selection;
. block 137 to return to the microstep list display;
. block 139 to expand the microstep.

Block 141 also permits access to a data base (DB) (block 145 after block 141) containing further past in-house design data relative to the microstep parameters. Any other data is selected in a block 146 following block 145, and which also provides for returning to the expanded microstep display in block 139.

Block 140 displays a sixth video page (COMPONENT PAGE) showing a list of n standard in-house components, such as:
. component 1 (gear);
. component 2 (shaft);
. ...
. i-th component (casting);
. ...
. n-th component (bearing).

Each component in the block 140 list is also selected using normal known graphic environment means.

When a given component in the list is selected (e.g. gear), block 140 goes on to a block 156, which displays a seventh video page (COMPONENT DEVELOPMENT STEPS PAGE) showing a list of m steps necessary to develop the standard component selected, for example:
. gear feasibility study;
. gear definition project;
. detailed gear project;
. gear work project;
. gear testing;
. gear approval.

One or more of the block 156 steps can be selected by the operator, again using known graphic environment selection means.

When a given step in the list is selected, block 156 is followed by a block 157, which displays an eighth video page (MICROSTEP PAGE) showing a number of microsteps, which together define the selected step. The order in which the microsteps are listed corresponds to the logical and/or time sequence of the jobs involved in performing the selected step; and each microstep indicates the procedures to be performed in the microstep itself, as characterized by mathematical formulas and input and output parameters. The microstep sequence and content are based on previous in-house design experience.

When a given microstep in the list is selected, block 157 goes on to a block 159, which provides for expanding the selected microstep, i.e. indicates, in as much detail as the system allows, the operations involved in the microstep according to previous in-house design experience.

Block 159 may display for each microstep:
. microstep input parameter tables;
. microstep output parameter tables;
. microstep processing procedures;
. useful microstep tools, e.g. program and processing code lists.

Block 159 is followed by a block 160 enabling operator access to:
. block 120 (MAIN block) showing the main video page from which to make a further product, component or discipline option selection;
. block 157 to return to the microstep list display;
. block 159 to expand the microstep.

Block 160 also permits access to a data base (block 165 after block 160) containing further data relative to the microstep parameters. Any other data is selected in a block 166 following block 165, and which also provides for returning to the expanded microstep display in block 159.

Block 150 displays a ninth video page (DISCIPLINE PAGE) showing a list of company-related disciplines, such as:
. discipline 1 (material analysis);
. discipline 2 (thermostructural analysis);
. ...
. i-th discipline (thermodynamics);
. ...
. k-th discipline (mechanical project).

Each discipline in the block 150 list is also selected using normal known graphic environment means.

When a given discipline in the list is selected (e.g. material analysis), block 150 goes on to a block 170, which displays a tenth video page (DISCIPLINE SUBSECTION SELECTION) showing a list of subsections of the selected discipline:
. subsection 1 (basics);
. subsection 2 (tools);
. ...
. i-th subsection (applications);
. ...
. 1-th subsection.

Each subsection in the block 170 list is also selected using normal known graphic environment means.

When a given subsection in the list is selected, block 170 supplies detailed technical-scientific information - information used in past design work - relative to the selected subsection of the selected discipline.

Once the block 170 inquiry is completed, block 170 is followed by a block 177, which provides for:
. returning to the discipline list (block 150);
. returning to block 120.

In actual use, after activating the system, the system operator can either select access to the manual (block 110) or make a system inquiry (block 120). If the first operating mode (block 130) is selected, a list of standard in-house products is displayed for selection by the operator. Following selection, the necessary steps to develop the selected product are displayed (block 136); the operator selects the pertinent step (block 136), i.e. the one relevant to current design requirements, and is then provided with the various microsteps indicating as a whole the logical and/or time sequence of design jobs to be performed.

The system therefore provides for directing and organizing the design work of the operator.

Each expanded microstep (block 139) provides the operator with further detailed design tools, so that the operator is provided with all the technical "means" by which to do the job.

In particular, the operator is allowed access to:
. microstep input parameter tables;
. microstep output parameter tables;
. microstep processing procedures;
. useful microstep tools, e.g. program and processing code lists.

The operator also has access to a large data base (block 145) containing further microstep parameter data.

Moreover, the tools and data supplied are "proven", by having already been used in earlier in-house design work, which is thus made available to simplify, improve and expedite the design work of the operator, and to ensure this conforms with consolidated in-house design practices. The same obviously also applies to selection of block 140 and following blocks 156-166.

The system according to the present invention may also be equipped with a processing device featuring meta languages (e.g. XML language) and for automatically receiving into its data base (blocks 145, 165) parameter data relative to a completed project developed according to the system, so that new projects developed according to the system of the present invention provide for automatically loading the data bases.

Alternatively, the data bases of blocks 145 and 165 may be replaced by a single data base accessed by the operator from both blocks 141 and 160.

## Claims

1. A computer-assisted design system for use by a company, comprising:
- first display and selection means (130) for commanding the video display (PRODUCT PAGE) of a list of standard in-house products; said first display and selection means (130) permitting selection of the various standard displayed products;
- second display and selection means (136), which are activated following selection of a said displayed product to command the video display (PRODUCT STEP PAGE) of a list of steps necessary to develop the selected standard product; said second display and selection means (136) permitting selection of the various displayed steps; **characterised by** further comprising:
- third display and selection means (137), which are activated following selection of a said displayed step to command display (MICROSTEP PAGE) of a number of microsteps defining, as a whole, the previously selected step; the order of said microsteps corresponding to the logical and/or time sequence of the jobs involved in performing the selected step; each microstep indicating the procedures to be performed in the microstep, as **characterized by** formulas, input parameters and output parameters; and said sequence of microsteps being based on in-house design experience to provide an operator using said system with technical information which may be used in designing said product.

2. A system as claimed in Claim 1, **characterized by** also comprising first selection means for selecting said microsteps and permitting selection of at least one microstep to select first expansion means (139) for expanding the selected microstep and displaying, in as much detail as the system allows, the operations defined by the microstep on the basis of in-house design experience.

3. A system as claimed in Claim 2, **characterized in that** said first expansion means (139) display for each microstep:
- tables of input parameters by which to perform the microstep;
- tables of output parameters by which to perform the microstep;
- processing procedures by which to perform the operations in the microstep; and
- tools for use in the microstep, such as a program list and a processing code list.

4. A system as claimed in Claim 3, **characterized in that** said first expansion means (139) permit access (141) to a data base (145) in which is stored further previous in-house experience data relative to the microstep parameters.

5. A system as claimed in any one of the foregoing Claims, **characterized by** comprising:
- fourth display and selection means (140) for commanding the video display (COMPONENT PAGE) of a list of standard in-house components; said fourth display and selection means (140) permitting selection of the various standard displayed components;
- fifth display and selection means (156), which are activated following selection of a said displayed component to command the video display (COMPONENT STEP PAGE) of a list of steps necessary to develop the selected standard component; said fifth display and selection means (156) permitting selection of the various displayed steps;
- sixth display and selection means (157), which are activated following selection of a said displayed step to command display (MICROSTEP PAGE) of a number of microsteps defining, as a whole, the previously selected step; the order of said microsteps corresponding to the logical and/or time sequence of the jobs involved in performing the selected step; each microstep indicating the procedures to be performed in the microstep, as **characterized by** formulas, input parameters and output parameters; and said sequence of microsteps being based on in-house design experience to provide an operator using said system with technical information which may be used in designing said component.

6. A system as claimed in Claim 5, **characterized by** also comprising second selection means for selecting said microsteps and permitting selection of at least one microstep to select second expansion means for expanding the selected microstep and displaying, in as much detail as the system allows, the operations defined by the microstep on the basis of previous in-house design experience.

7. A system as claimed in Claim 5, **characterized in that** said second expansion means (159) display for each microstep:
- tables of input parameters by which to perform the microstep;
- tables of output parameters by which to perform the microstep;
- processing procedures by which to perform the operations in the microstep;
- tools for use in the microstep, such as a program list and a processing code list.

8. A system as claimed in Claim 7, **characterized in that** said second expansion means (159) permit access (160) to a data base (165) in which is stored further previous in-house experience data relative to the microstep parameters.

9. A system as claimed in any one of the foregoing Claims, **characterized by** comprising:
- seventh display and selection means (150) for displaying a list of company-related scientific disciplines; said seventh display and selection means (150) permitting selection of the various displayed disciplines; and
- eighth display and selection means (170), which are activated following selection of a said discipline to command the video display (DISCIPLINE SUBSECTION SELECTION) of a number of subsections of the selected discipline; said eighth display and selection means (170) permitting selection of the various displayed subsections to provide detailed technical-scientific information relative to the selected subsection of the previously selected discipline.

10. A system as claimed in any one of the foregoing Claims, **characterized by** comprising a processing device having meta languages, in particular the XML language, and for automatically receiving into its data base (145, 165) data relative to the parameters of a completed project developed according to said system, so that new projects developed according to said system of the present invention provide for automatically loading said data base.

## Patentansprüche

1. Computergestütztes Konstruktionssystem zum Einsatz in einem Unternehmen, mit
- Ersten Anzeige- und Auswahlmitteln (130) zum Steuern der Bildschirmanzeige (PRODUKTSEITE) einer Liste von hausinternen Standardprodukten; wobei die ersten Anzeige- und Auswahlmittel (130) die Auswahl der verschiedenen angezeigten Standardprodukte erlauben;
- Zweiten Anzeige- und Auswahlmitteln (136), die infolge der Auswahl eines angezeigten Produkts aktiviert werden, um die Bildschirmanzeige (PRO-DUKTSCHRITT-SEITE) einer Liste von Schritten zu steuern, die zur Entwicklung des ausgewählten Standardprodukts notwendig sind; wobei die zweiten Anzeige- und Auswahlmittel (136) die Auswahl der verschiedenen angezeigten Schritte ermöglichen, weiterhin **gekennzeichnet durch**
- Dritte Anzeige- und Auswahlmittel (137), die infolge der Auswahl eines angezeigten Schritts aktiviert werden, um die Anzeige (MIKROSCHRITT-SEITE) einer Anzahl von Mikroschritten zu steuern, die im Ganzen genommen, den davor ausgewählten Schritt definieren; wobei die Reihenfolge der Mikroschritte der logischen und/oder zeitlichen Folge der mit der Durchführung des ausgewählten Schritts verbundenen Arbeiten entspricht; wobei jeder Mikroschritt die im Mikroschritt durchzuführenden Verfahren - typisch Formeln, Eingabeparameter und Ausgabeparameter - angibt; und wobei die Folge der Mikroschritte auf hausinternen Konstruktionserfahrungen beruht, um den das System benutzenden Bedienenden mit technischen Informationen zu versorgen, die bei der Konstruktion des Produktes zum Einsatz kommen können.

2. System nach Anspruch 1, ferner **gekennzeichnet durch** erste Auswahlmittel zur Auswahl der Mikroschritte und Ermöglichung der Auswahl von mindestens einem Mikroschritt, um erste Erweiterungsmittel (139) zum Erweitern des ausgewählten Mikroschritts auszuwählen und um die **durch** den Mikroschritt definierten Arbeiten in so viel Detail, wie das System erlaubt; auf der Basis der hausinternen Konstruktionserfahrungen anzuzeigen.

3. System nach Anspruch 2, **dadurch gekennzeichnet, dass** die ersten Erweiterungsmittel (139) für jeden Mikroschritt Folgendes anzeigen:
- Eingabeparametertabellen, die bei der Durchführung des Mikroschritts zum Einsatz kommen;
- Ausgabeparametertabellen, die bei der Durchführung des Mikroschritts zum Einsatz kommen;
- Verarbeitungsverfahren, die bei der Durchführung der Arbeiten im Mikroschritt zum Einsatz kommen; und
- Werkzeuge zum Einsatz in dem Mikroschritt, wie zum Beispiel eine Programmliste und eine Verarbeitungscodeliste.

4. System nach Anspruch 3, **dadurch gekennzeichnet, dass** die ersten Erweiterungsmittel (139) Zugriff (141) auf eine Datenbank (145) erlauben, in der weitere frühere hausinterne Erfahrungsdaten gespeichert sind, die sich auf Mikroschritt-Parameter beziehen.

5. System nach einem der vorhergehenden Ansprüche, **gekennzeichnet durch**:
- Vierte Anzeige- und Auswahlmittel (140) zum Steuern der Bildschirmanzeige (BAUTEIL-SEITE) einer Liste von hausinternen Standardbauteilen; wobei die vierten Anzeige- und Auswahlmittel (140) die Auswahl der verschiedenen angezeigten Standardbauteile erlauben;
- fünfte Anzeige- und Auswahlmittel (156), die nach Auswahl eines angezeigten Bauteils aktiviert werden, um die Bildschirmanzeige (BAUTEILSCHRITT-SEITE) einer Liste von Schritten zu steuern, die zur Entwicklung des ausgewählten Standardbauteils notwendig sind; wobei die fünften Anzeige- und Auswahlmittel (156) die Auswahl der verschiedenen angezeigten Schritte erlauben;
- sechste Anzeige- und Auswahlmittel (157) die nach Auswahl eines angezeigten Schritts aktiviert werden, um die Anzeige (MIKROSCHRITT-SEITE) einer Anzahl von Mikroschritten zu steuern, die im Ganzen genommen, den davor ausgewählten Schritt definieren; wobei die Reihenfolge der Mikroschritte der logischen und/oder zeitlichen Folge den mit der Durchführung des ausgewählten Schritts verbundenen Arbeiten entspricht; wobei jeder Mikroschritt die in dem Mikroschritt durchzuführenden Verfahren - typisch Formeln, Eingabeparameter und Ausgabeparameter - angibt; und wobei die Folge der Mikroschritte auf den hausinternen Konstruktionserfahrungen beruht, um einen das System benutzenden Bedienenden mit technischen Informationen zu versorgen, die bei der Konstruktion des Bauteils zum Einsatz kommen können.

6. System nach Anspruch 5, ferner **gekennzeichnet durch** zweite Auswahlmittel zur Auswahl der Mikroechritte und Ermöglichung der Auswahl von mindestens einem Mikroschritt, um zweite Erweiterungsmittel zum Erweitern des ausgewählten Mikroschritts auszuwählen, und um die in dem Mikroschritt definierten Arbeiten in so viel Detail, wie das System erlaubt, auf der Basis der früheren hausinternen Konstruktionserfahrungen anzuzeigen.

7. System nach Anspruch 5, **dadurch gekennzeichnet, dass** die zweiten Erweiterungsmittel (159) für jeden Mikroschritt Folgendes anzeigen:
- Eingabeparametertabellen, die bei der Durchführung des Mikroschritts zum Einsatz kommen;
- Ausgabeparametertabellen, die bei der Durchführung des Mikroschritts zum Einsatz kommen;
- Verarbeitungsverfahren, die bei der Durchführung der Arbeiten im Mikroschritt zum Einsatz kommen;
- Werkzeuge zum Einsatz in dem Mikroschritt, wie zum Beispiel eine Programmliste und eine Verarbeitungscodeliste.

8. System nach Anspruch 7, **dadurch gekennzeichnet dass** die zweiten Erweiterungsmittel (159) Zugriff (160) auf eine Datenbank (165) erlauben, in der weitere frühere hausinternen Erfahrungsdaten gespeichert sind, die sich auf die Mikroschrittparameter beziehen.

9. System nach einem der vorhergehenden Ansprüche, **gekennzeichnet durch**:
- Siebte Anzeige- und Auswahlmittel (150) zur Anzeige einer Liste mit unternehmensbezogenen wissenschaftlichen Disziplinen; wobei die siebten Anzeigeund Auswahlmittel (150) die Auswahl verschiedener angezeigter Disziplinen erlauben; und
- Achte Anzeige- und Auswahlmittel (170), die nach Auswahl einer Disziplin aktiviert werden, um die Bildschirmanzeige (DISZIPLIN-UNTERABSCHNITT-AUSWAHL) einer Anzahl von Unterabschnitten der ausgewählten Disziplin zu steuern; wobei die achten Anzeige- und Auswahlmittel (170) die Auswahl der verschiedenen angezeigten Unterabschnitte erlauben, um detaillierte technischwissenschaftliche Informationen bereitzustellen, die sich auf den ausgewählten Unterabschnitt der davor ausgewählten Disziplin beziehen.

10. System nach einem der vorhergehenden Ansprüche, **gekennzeichnet durch** ein Verarbeitungsgerät, das Metasprachen, insbesondere die XML-Sprache aufweist, und das automatisch Daten in seine Datenbank (145, 165) aufnimmt, die sich auf die Parameter eines fertig gestellten, nach dem System entwickelten Projekts beziehen, so dass neue Projekte, die nach dem erfindungsgemäßen System entwickelt werden, die Datenbank automatisch laden können.

## Revendications

1. Un système de conception assistée par ordinateur destiné à être utilisé par une entreprise, comprenant :
- des premiers moyens d'affichage et de sélection (130) pour la commande de l'affichage vidéo (PAGE PRODUIT) d'une liste de produits internes standards ; lesdits premiers moyens d'affichage et de sélection (130) permettant la sélection des différents produits affichés standards ;
- des seconds moyens d'affichage et de sélection (136) qui sont activés à la suite de la sélection d'un dit produit affiché pour commander l'affichage vidéo (PAGE ETAPE PRODUIT) d'une liste d'étapes nécessaires au développement du produit standard sélectionné ; lesdits seconds moyens d'affichage et de sélection (136) permettant la sélection des différentes étapes affichées ; **caractérisé en ce qu'**il comprend, en outre :
- des troisièmes moyens d'affichage et de sélection (137) qui sont activés à la suite de la sélection d'une dite étape affichée pour commander l'affichage (PAGE MICRO-ETAPE) d'un nombre de micro-étapes définissant, dans son ensemble, l'étape précédemment sélectionnée ; l'ordre desdites micro-étapes correspondant à la séquence logique et/ou temporelle des travaux impliqués dans l'exécution de l'étape sélectionnée ; chaque micro-étape indiquant les procédures à réaliser dans la micro-étape, tel que **caractérisé par** les formules, les paramètres d'entrée et les paramètres de sortie : et ladite séquence de micro-étapes étant basée sur l'expérience de conception inteme afin de foumir à un opérateur utilisant ledit système des informations techniques qui peuvent être utilisées dans la conception dudit produit.

2. Un système tel que revendiqué dans la revendication 1, **caractérisé en ce qu'**il comprend également des premiers moyens de sélection pour sélectionner lesdites micro-étapes et permettre la sélection d'une micro-étape au moins afin de sélectionner des premiers moyens d'extension (139) à des fins d'extension de la micro-étape sélectionnée et d'affichage, de manière aussi détaillée que le système le permet, des opérations définies par la micro-étape sur la base de l'expérience de conception interne.

3. Un système tel que revendiqué dans la revendication 2, **caractérisé en ce que** lesdits premiers moyens d'extension (139) affichent pour chaque micro-étape :
- les tables des paramètres d'entrée selon lesquels exécuter la micro-étape ;
- les tables des paramètres de sortie selon lesquels exécuter la micro-étape ;
- les procédures de traitement selon lesquelles exécuter les opérations de la micro-étape ; et
- les outils à utiliser dans la micro-étape, tels qu'une liste de programme et une liste de codes de traitement.

4. Un système tel que revendiqué dans la revendication 3, **caractérisé en ce que** lesdits premiers moyens d'extension (139) permettent l'accès (141) à une base de données (145) dans laquelle sont stockées d'autres données sur la précédente expérience inteme relatives aux paramètres de la micro-étape.

5. Un système tel que revendiqué dans l'une quelconque des précédentes revendications, **caractérisé en ce qu'**il comprend
- des quatrièmes moyens d'affichage et de sélection (140) pour la commande de l'affichage vidéo (PAGE COMPOSANT) d'une liste de composants intemes standards ; lesdits quatrièmes moyens d'affichage et de sélection (140) permettant la sélection des différents composants affichés standards ;
- des cinquièmes moyens d'affichage et de sélection (156) qui sont activés à la suite de la sélection d'un dit composant affiché pour commander l'affichage vidéo (PAGE ETAPE COMPOSANT) d'une liste d'étapes nécessaires au développement du composant standard sélectionné ; lesdits cinquièmes moyens d'affichage et de sélection (156) permettant la sélection des différentes étapes affichées ;
- des sixièmes moyens d'affichage et de sélection (157) qui sont activés à la suite de la sélection d'une dite étape affichée pour commander l'affichage (PAGE MICRO-ETAPE) d'un nombre de micro-étapes définissant, dans son ensemble, l'étape précédemment sélectionnée ; l'ordre desdites micro-étapes correspondant à la séquence logique et/ou temporelle des travaux impliqués dans l'exécution de l'étape sélectionnée ; chaque micro-étape indiquant les procédures à réaliser dans la micro-étape, tel que **caractérisé par** les formules, les paramètres d'entrée et les paramètres de sortie ; et ladite séquence de micro-étapes étant basée sur l'expérience de conception interne afin de fournir à un opérateur utilisant ledit système des informations techniques qui peuvent être utilisées dans la conception dudit composant.

6. Un système tel que revendiqué dans la revendication 5, **caractérisé en ce qu'**il comprend également des seconds moyens de sélection pour sélectionner lesdites micro-étapes et permettre la sélection d'une micro-étape au moins afin de sélectionner des seconds moyens d'extension à des fins d'extension de la micro-étape sélectionnée et d'affichage, de manière aussi détaillée que le système le permet, des opérations définies par la micro-étape sur la base de la précédente expérience de conception interne.

7. Un système tel que revendiqué dans la revendication 5, **caractérisé en ce que** lesdits seconds moyens d'extension (159) affichent pour chaque micro-étape :
- les tables des paramètres d'entrée selon lesquels exécuter la micro-étape ;
- les tables des paramètres de sortie selon lesquels exécuter la micro-étape ;
- les procédures de traitement selon lesquelles exécuter les opérations de la micro-étape ; et
- les outils à utiliser dans la micro-étape, tels qu'une liste de programmes et une liste de codes de traitement.

8. Un système tel que revendiqué dans la revendication 7, **caractérisé en ce que** lesdits seconds moyens d'extension (159) permettent l'accès (160) à une base de données (165) dans laquelle sont stockées d'autres données sur la précédente expérience interne relatives aux paramètres de la micro-étape.

9. Un système tel que revendiqué dans l'une quelconque des précédentes revendications, **caractérisé en ce qu'**il comprend :
- des septièmes moyens d'affichage et de sélection (150) pour l'affichage d'une liste de disciplines scientifiques concemant l'entreprise ; lesdits septièmes moyens d'affichage et de sélection (150) permettant la sélection des différentes disciplines affichées ; et
- des huitièmes moyens d'affichage et de sélection (170) qui sont activés à la suite de la sélection d'une dite discipline pour commander l'affichage vidéo (SELECTION DE SOUS-SECTION DE DISCIPLINE) d'un nombre de sous-sections de la discipline sélectionnée ; lesdits huitièmes moyens d'affichage et de sélection (170) permettant la sélection des différentes sous-sections affichées pour fournir des informations techniques/scientifiques détaillées relatives à la sous-section sélectionnée de la disclpline précédemment sélectionnée.

10. Un système tel que revendiqué dans l'une quelconque des précédentes revendications, **caractérisé en ce qu'**il comprend un dispositif de traitement doté de méta-langages, en particulier le langage XML, et pour la réception automatique dans sa base de données (145, 165) des données relatives aux paramètres d'un projet terminé développé en accord avec ledit système, de telle sorte que les nouveaux projets développés en accord avec ledit système de la présente invention assurent le chargement automatique de ladite base de données.
